# EUROPEAN PATENT APPLICATION

(11) **EP 1 653 695 A2**
(43) Date of publication of application: **03.05.2006**
(21) Application number: 05256459.8
(22) Date of filing: 18.10.2005
(51) Int. Cl.: H04L 27/38

(54) **I/Q quadrature demodulator with single common voltage to current input stage for both I and Q**

(30) Priority: 30.10.2004 KR 2004087593
(71) Applicant: Samsung Electronics Co., Ltd., Suwon-si, Gyeonggi-Do (KR)
(72) Inventor: Kim, Dae-yeon, Suwon-si, Gyeonggi-do (KR); Ryu, Jae-young, Suwon-si, Gyeonggi-do (KR)
(74) Representative: Brandon, Paul Laurence

(57) **Abstract**

An I/Q quadrature demodulator converts a frequency of a radio frequency (RF) signal, and has characteristics of low voltage and noise in a wireless communication receiver. The I/Q quadrature demodulator includes an input terminal that converts an input RF signal into a RF current signal and is shared by an I mixer and a Q mixer, and the I mixer and the Q mixer receive the input RF current signal from the input terminal and output an I signal and a Q signal, respectively. The I mixer and the Q mixer share a single input terminal, thereby reducing power consumption, increasing conversion gain, and reducing a noise figure.

## Description

The present invention relates to demodulators used in a wireless communication receiver.

Wireless communication has rapidly developed. In particular, great efforts have been made to miniaturize and increase integration in electronic devices used for wireless communication. It is important to reduce the power consumption of electronic devices in order to increase the time for which a wireless communication terminal can be used. In a wireless communication system, when a transmitter transmits information-bearing signal modulated by a carrier having a high frequency, a receiver converts the modulated RF signal having a high frequency into a radio frequency (RF) signal having a low frequency, and restores information included in the demodulated RF signal having the low frequency using a predetermined interpretive means.

Wireless communication receivers can use two different categories of superhetereodyne and direct-conversion.

The superhetereodyne type that converts a carrier frequency to an intermediate frequency (IF) and then converts the IF to a baseband frequency is applied to a variety of communication systems.

The direct-conversion type that directly converts the carrier frequency to the baseband frequency does not require a band pass filter (BPF), a down converter, and a local oscillator (LO) necessary for IF, making the wireless communication system simple. This direct-conversion type is increasingly used in wireless LAN (802.11 a/b/g) terminals.

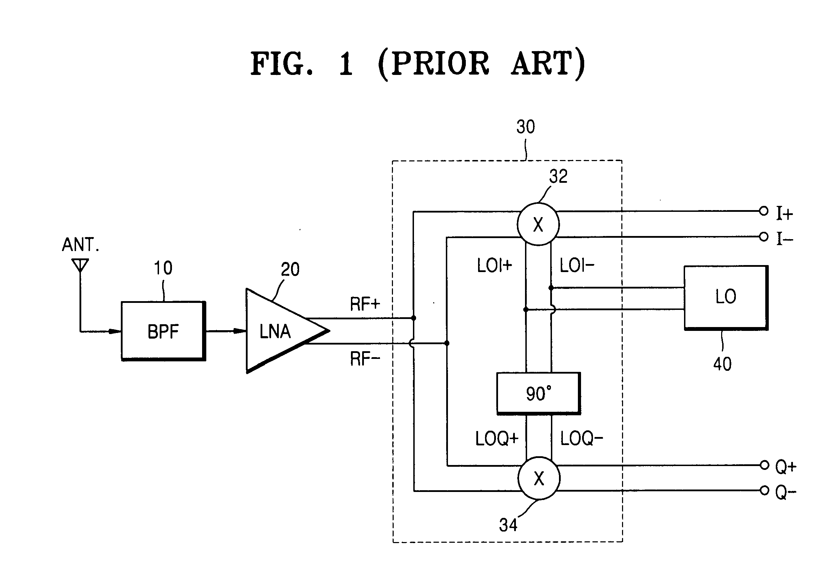

FIG. 1 is a schematic block diagram of a direct-conversion wireless communication receiver. Referring to FIG. 1, the receiver comprises an antenna ANT for receiving radio frequency (RF) signals, a band pass filter (BPF) 10 for extracting a RF signal of a desired frequency band from RF signals received using the antenna ANT, a low noise amplifier (LNA) 20 for amplifying the RF signal extracted by the BPF 10 with minimizing a noise, a local oscillator (LO) 40 for generating an oscillation signal having a predetermined frequency, and a demodulator 30 for converting the frequency of the RF signal using output signals from the LO 40 and the LNA 20, and outputting an in-phase signal (hereinafter referred to as an I signal) and a quadrature phase signal (hereinafter referred to as a Q signal) having a phase difference of 90° therebetween. The I signal and the Q signal have a frequency corresponding to the difference between the frequencies of the RF signal and the LO 40.

The demodulator 30 includes an I mixer 32 and a Q mixer 34 that receive the oscillation signal from the LO 40 and the RF signal, and convert the frequency of the RF signal. The I mixer 32 and the Q mixer 34 are composed of transistors that turn on and off according to the oscillation signal of the LO 40 to convert the frequency of the RF signal and output the I signal and the Q signal, respectively.

The I mixer 32 and the Q mixer 34 that convert frequency of the RF signal are critical constituents that influence overall gain or noise of the receiver. The I mixer 32 and the Q mixer 34 are designed to consider conversion gain, performance of the LO 40, linearity, noise figure (NF), voltage supply, power consumption, and the like.

A conventional mixer, for example, is a Gilbert mixer. The Gilbert mixer using a cascade structure has a stable and superior linearity while requiring a relatively higher voltage. The Gilbert mixer is mainly used in superheterodyne receivers, while a folded mixer is advantageous to a direct-conversion receiver. This is because the folded mixer has a better noise characteristic than the Gilbert mixer, and operates at low voltage.

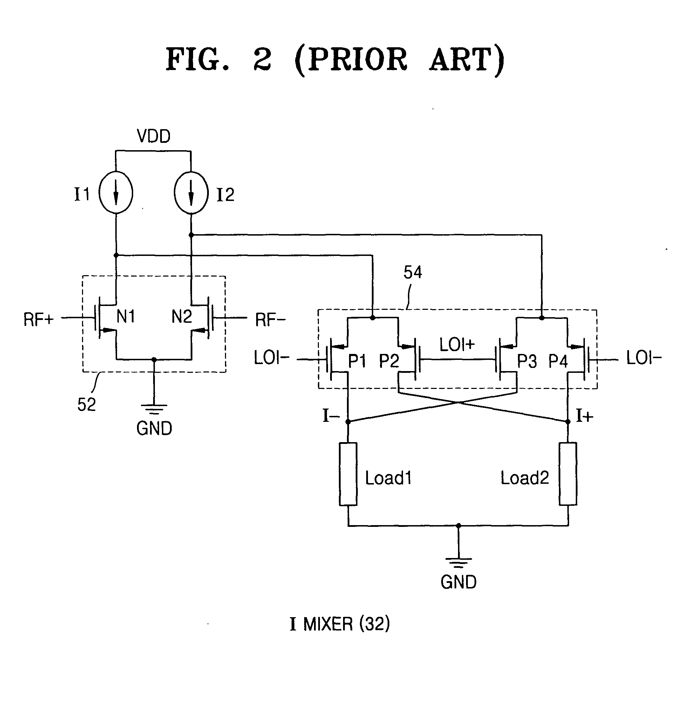

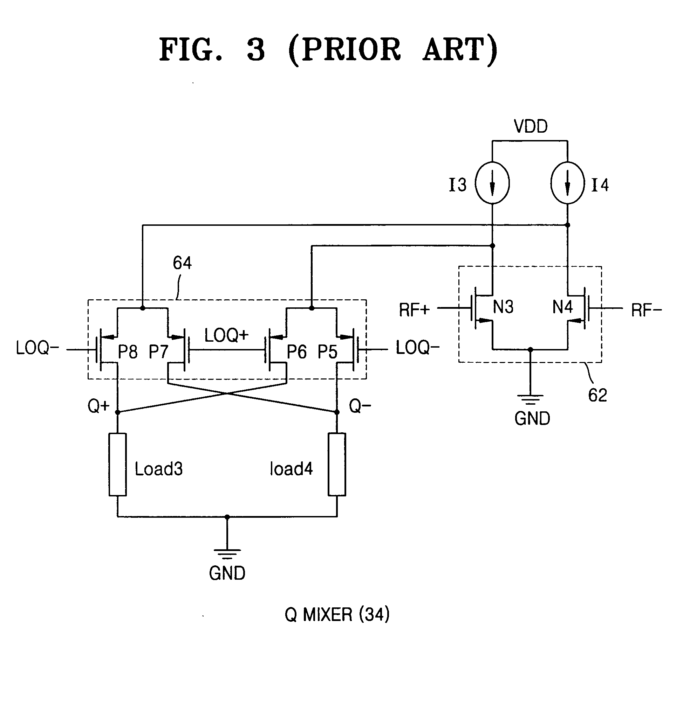

FIG. 2 is a block diagram of a conventional folded mixer to which the I mixer 32 of FIG. 1 is applied, and FIG. 3 is a block diagram of a conventional folded mixer to which the Q mixer 34 of FIG. 1 is applied.

Referring to FIG. 2, the folded I mixer 32 comprises a transconductance unit 52 for converting a RF voltage signal into a RF current signal, and a switching pair unit 54 turned on/off by differential in-phase oscillation signals LOI+ and LOI- from the LO 40 and converting the frequency of the RF current signal that was converted in the transconductance unit 52.

The transconductance unit 52 includes NMOS transistors N1 and N2 that are biased by current sources I1 and I2, and convert differential RF voltage signals RF+ and RF- into RF current signals.

The switching pair unit 54 includes PMOS transistors P1 to P4 that are operated by differential in-phase oscillation signals LOI+ and LOI- from the LO 40, and convert the frequency of the RF signal.

Referring to FIG. 3, the folded Q mixer 34 comprises a transconductance unit 62 and a switching pair unit 64 in the same manner as the folded I mixer 32. The folded Q mixer 34 receives differential quadrature phase oscillation signals LOQ+ and LOQ- having a phase difference of 90° with the differential in-phase oscillation signals LOI+ and LOI- to operate the switching pair unit 64, and converts the frequency of the RF signal. That is, the folded I mixer 32 and folded Q mixer 34 have the same LO frequency to operate the switching pair units 54 and 64, while signals LOQ and LOI have a phase difference of 90°.

The folded I mixer 32 and folded Q mixer 34 convert the frequency of the RF signal using the oscillation signal from the LO 40, and each output differential I signals I+ and I-, and Q signals Q+ and Q- having a phase difference of 90°. The transconductance units 52 and 62, which have the same constitution and are formed in the folded I mixer 32 and folded Q mixer 34, respectively, consume the bulk of power in an I/Q quadrature demodulator. Therefore, a conventional I/Q quadrature demodulator that includes transconductance units 52 and 62 in the folded I mixer 32 and folded Q mixer 34, respectively, has a problem of power consumption.

Preferred embodiments of the present invention aim to provide an I/Q quadrature demodulator capable of increasing the time for which a wireless communication terminal can be used by reducing power consumption.

Preferred embodiments of the present invention also aim to provide an I/Q quadrature demodulator capable of improving receive performance by reducing power consumption and improving a noise characteristic.

According to an aspect of the present invention, there is provided an I/Q quadrature demodulator that converts a high-frequency signal into an I/Q signal and outputs the I/Q signal, the I/Q quadrature demodulator comprising: an input terminal outputting current in response to voltage of RF signal, the input terminal shared by an I mixer and a Q mixer; the I mixer converting a frequency of a current signal output from the input terminal, and outputting a differential in-phase IF signal; and the Q mixer converting a frequency of a current signal output from the input terminal, and outputting a differential quadrature-phase IF signal.

According to another aspect of the present invention, there is provided an I/Q quadrature demodulator that converts a high-frequency signal into an I/Q signal and outputs the I/Q signal, the I/Q quadrature demodulator comprising: an input terminal outputting current in response to voltage of RF signal, the input terminal shared by an I mixer and a Q mixer; the I mixer converting a frequency of a current signal output from the input terminal, receiving a differential in-phase oscillation signal from local oscillator, and outputting a differential in-phase IF signal; and the Q mixer converting a frequency of a current signal output from the input terminal, and outputting a differential quadrature-phase IF signal.

According to still another aspect of the present invention, there is provided an I/Q quadrature demodulator that converts a high-frequency signal into an I/Q signal and outputs the I/Q signal, the I/Q quadrature demodulator comprising: a first path unit comprising a pair of NMOS transistors N1 and N2 that output current in response to a voltage of an input RF signal; and a second path unit connected to the first path unit in parallel, and comprising a pair of PMOS transistors PM1 and PM2 that output current in response to a voltage of the input RF signal; an I mixer connected to drain terminals of the transistors, converting a frequency of the input RF signal by receiving an input differential in-phase oscillation signal from a local oscillator, and outputting an I signal; and a Q mixer connected to drain terminals of the transistors, converting a frequency of the input RF signal by receiving an input differential quadrature-phase oscillation signal from the local oscillator in a gate terminal, and outputting a Q signal, wherein drain terminals of the transistors PM1 and N1 are connected to each other, and drain terminals of the transistors PM2 and N2 are connected to each other.

Further features of the present invention are set out in the appended claims.

The present invention will become more apparent by describing in detail exemplary embodiments thereof with reference to the attached drawings in which:
FIG. 1 is a schematic block diagram of a direct-conversion wireless communication receiver;
FIG. 2 is a block diagram of a conventional folded mixer to which the I mixer 32 of FIG. 1 is applied;
FIG. 3 is a block diagram of a conventional folded mixer to which the Q mixer 34 of FIG. 1 is applied;
FIG. 4 is a block diagram of an I/Q quadrature demodulator according to an exemplary embodiment of the present invention;
FIG. 5 is a circuit diagram of the I/Q quadrature demodulator according to an exemplary embodiment of the present invention;
FIG. 6 is a circuit diagram of an I/Q quadrature demodulator according to another exemplary embodiment of the present invention; and
FIG. 7 is a graph illustrating noise figure (NF) curves of the I/Q quadrature demodulator according to an exemplary embodiment of the present invention and a conventional I/Q quadrature demodulator.

Hereinafter, the present invention will be described in detail by explaining exemplary embodiments of the invention with reference to the attached drawings.

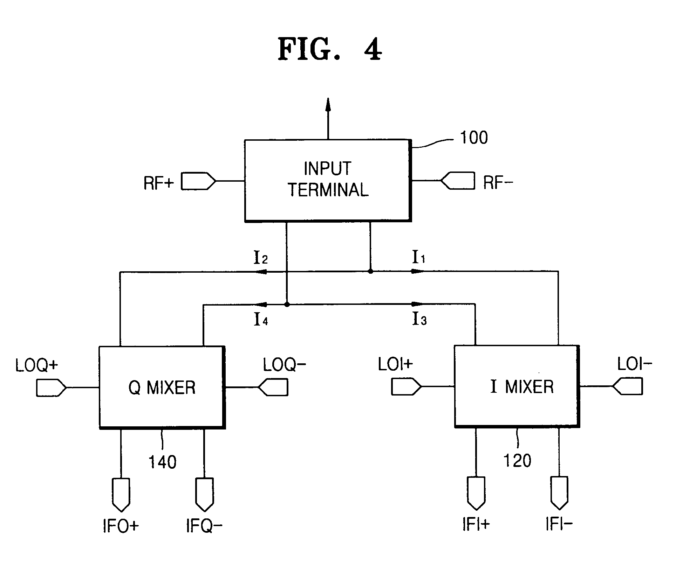

FIG. 4 is a block diagram of an I/Q quadrature demodulator according to an exemplary embodiment of the present invention. Referring to FIG. 4, the I/Q quadrature demodulator comprises an input terminal 100, an I mixer 120, and a Q mixer 140, and has a mirror symmetry structure. With the input terminal 100 centered, the I mixer 120 for converting the frequency of an in-phase signal (I signal) is symmetrical to the Q mixer 140 for converting the frequency of a quadrature phase signal (Q signal). There is a phase difference of 90° between the I signal and the Q signal.

The input terminal 100 receives differential RF voltage signals RF+ and RF- and converts them into current signals I₁ to I₄. Current signals I₁ and I₃ are input into the I mixer 120, and current signals I₂ and I₄ are input into the Q mixer 140. Current signals I₁ and I₃ differ from current signals I₂ and I₄ in phase by 180°.

The I mixer 120 receives current signals I₁ and I₃ from the input terminal 100 and differential in-phase oscillation signals LOI+ and LOI-. A local oscillator (LO) (not shown) outputs the differential in-phase oscillation signals LOI+ and LOI-. The frequencies of the differential in-phase oscillation signals LOI+ and LOI- depend on the frequency of a input RF signal and the frequency of the RF signal to be converted.

The I mixer 120 converts frequency of the RF signal using current signals I₁ and I₃ and differential in-phase oscillation signals LOI+ and LOI- and outputs differential in-phase IF signals IFI+ and IFI-.

The Q mixer 140 receives current signals I₂ and I₄ from the input terminal 100 and differential quadrature-phase oscillation signals LOQ+ and LOQ-. An LO outputs differential quadrature-phase oscillation signals LOQ+ and LOQ- in the same manner as differential in-phase oscillation signals LOI+ and LOI-. The Q mixer 140 converts the frequency of the RF signal using current signals I₂ and I₄ and differential quadrature-phase oscillation signals LOQ+ and LOQ- and outputs differential quadrature-phase IF signals IFQ+ and IFQ-.

The differential in-phase IF signals IFI+ and IFI- and differential quadrature-phase IF signals IFQ+ and IFQ- have a differential voltage mode, and a frequency component corresponding to a sum of the frequency of the RF signal and the frequency of the oscillation signal from the LO and a difference between the frequency of the RF signal and the frequency of the oscillation signal from the LO.

In the I/Q quadrature demodulator according to an exemplary embodiment of the present invention, two input terminals corresponding to conventional transconductance units that are connected to both the I mixer and the Q mixer, and convert the RF signal into a current signal, are reduced to a single input terminal, thereby reducing power consumption.

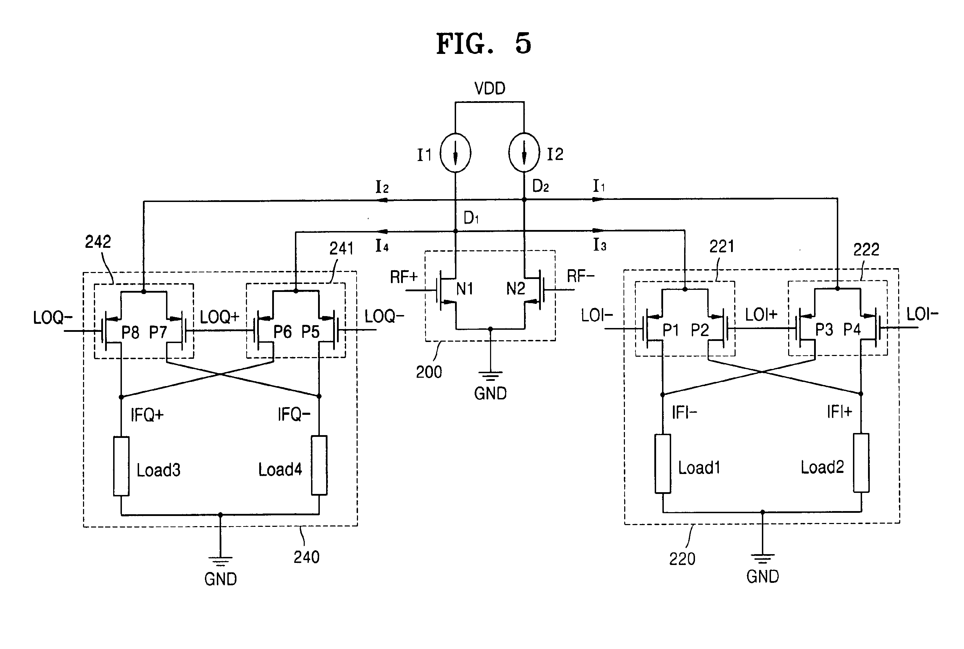

FIG. 5 is a circuit diagram of an I/Q quadrature demodulator according to an exemplary embodiment of the present invention. A bias circuit for operating an MOS transistor, which is left out from FIG. 5, can be embodied in a variety of forms by those having average skill in the art. The bias circuit is designed to consider the linearity, gain, noise figure (NF), etc. of the I/Q quadrature demodulator.

Referring to FIG. 5, the I/Q quadrature demodulator comprises an input terminal 200, an I mixer 220, and a Q mixer 240.

The input terminal 200 includes a pair of first and second NMOS transistors N1 and N2 having a differential amplifier structure. The first and second NMOS transistors N1 and N2 have grounded source terminals. A gate terminal of the first NMOS transistor N1 is connected to a differential RF voltage signal RF+, and a gate terminal of a second NMOS transistor N2 is connected to a differential RF voltage signal RF-.

Current sources I1 and I2 for biasing the pair of NMOS transistors N1 and N2 are respectively connected between the drain terminal D1 and a voltage supply terminal VDD, and between the drain terminal D2 and voltage supply terminal VDD of the pair of NMOS transistors N1 and N2.

The I mixer 220 that converts frequency of the RF signal and outputs differential in-phase IF signals IFI+ and IFI- comprises a first PMOS transistor switching pair 221 and a second PMOS transistor switching pair 222.

The first PMOS transistor switching pair 221 includes two PMOS transistors P1 and P2 having a common source terminal, and has a differential amplifier structure. The common source terminal is connected to a drain terminal D1 of the first NMOS transistor N1, and receives a current signal I₃.

Likewise, the second PMOS transistor switching pair 222 includes two PMOS transistors P3 and P4 having a common source terminal, and has the differential amplifier structure. The common source terminal is connected to the drain terminal D2 of the second NMOS transistor N2, and receives a current signal I₁.

Gate terminals of the first and fourth PMOS transistors P1 and P4 are connected to a differential in-phase oscillation signal LOI- from the LO (not shown), and gate terminals of the second and third PMOS transistors P2 and P3 are connected to a differential in-phase oscillation signal LOI+ from the LO.

A drain terminal of the second PMOS transistor P2 is connected to a drain terminal of the fourth PMOS transistor P4, and a drain terminal of the first PMOS transistor P1 is connected to a drain terminal of the third PMOS transistor P3.

The drain terminals of the first to fourth PMOS transistors P1 to P4 are grounded through Loads 1 and 2.

The Q mixer 240, which converts the frequency of the RF signal and outputs differential quadrature-phase IF signals IFQ+ and IFQ-, comprises a third PMOS transistor switching pair 241 and a fourth PMOS transistor switching pair 242.

The third PMOS transistor switching pair 241 includes two PMOS transistors P5 and P6 having a common source terminal, and has a differential amplifier structure. The common source terminal is connected to the drain terminal D1 of the first NMOS transistor N1, and receives a current signal I₄.

Likewise, the fourth PMOS transistor switching pair 242 includes two PMOS transistors P7 and P8 having a common source terminal, and has a differential amplifier structure. The common source terminal is connected to a drain terminal D2 of the second NMOS transistor N2, and receives a current signal I₂.

Gate terminals of the sixth and seventh PMOS transistors P6 and P7 are connected to a differential quadrature-phase oscillation signal LOQ+ from the LO, and gate terminals of the fifth and eighth PMOS transistors P5 and P8 are connected to a differential quadrature-phase oscillation signal LOQ- from the LO.

A drain terminal of the fifth PMOS transistor P5 is connected to a drain terminal of the seventh PMOS transistor P7, and a drain terminal of the sixth PMOS transistor P6 is connected to a drain terminal of the eighth PMOS transistor P8.

The drain terminals of the fifth through eighth PMOS transistors P5 to P8 are grounded through Loads 3 and 4.

According to the I/Q quadrature demodulator, RF signals RF+ and RF- are converted into current signals by the input terminal 200, and the I mixer 220 and the Q mixer 240 convert the frequency of the current signals. As a result, the differential in-phase IF signals IFI+ and IFI- are output in a differential voltage mode between the first and second PMOS transistor switching pair 221 and 222, and Loads 1 and 2, and differential quadrature-phase IF signals IFQ+ and IFQ- are output in a differential voltage mode between the third and fourth PMOS transistor switching pair 241 and 242, and Loads 3 and 4.

Referring to FIG. 5, the operation of the I/Q quadrature demodulator will now be described.

Current that flows through drain terminals D1 and D2 of the first and second NMOS transistors N1 and N2 is determined by differential RF voltage signals RF+ and RF- which are input to the gate terminals of the first and second NMOS transistors N1 and N2 comprising the input terminal 200. That is, the differential RF voltage signals RF+ and RF- are converted into current signals.

Current that flows through drain terminals D1 and D2 of the first and second NMOS transistors N1 and N2 is branched off and input in the common source terminal of the first through fourth PMOS transistor switching pair 221, 222, 241, and 242.

To be more specific, the first and second PMOS transistor switching pair 221 and 222 constituting the I mixer 220 are switched on/off by the differential in-phase oscillation signals LOI+ and LOI- from LO, convert the frequency of the current signals I₁ and I₃ from the input terminal 200, and output the differential in-phase IF signals IFI+ and IFI-. It is assumed that f_{RF} is a frequency of the RF signal and f_{LO} is a frequency of the local oscillation signal from LO, then frequencies of the differential in-phase IF signals IFI+ and IFI- have frequency components corresponding to a sum f_{RF}+ f_{LO}, and a difference between f_{Rf} - f_{LO}. A frequency component corresponding to the difference is filtered using a filter, which makes it possible to convert a high-frequency RF signal into a low-frequency RF signal.

Likewise, the third and fourth PMOS transistor switching pair 241 and 242 constituting the Q mixer 240 are switched on/off by differential quadrature-phase oscillation signals LOQ+ and LOQI- from LO, convert the frequency of the current signals I₂ and I₄ from the input terminal 200, and output the differential quadrature-phase IF signals IFQ+ and IFQ-. Frequencies of the differential quadrature-phase IF signals IFQ+ and IFQ- are the same frequency as those of differential in-phase IF signals IFI+ and IFI-, i.e., frequency components corresponding to the sum f_{RF}+ f_{LO}, and the difference between f_{RF} - f_{LO}. However, the differential in-phase IF signals IFI+ and IFI- differ from the differential quadrature-phase IF signals IFQ+ and IFQ- in phase by 90°.

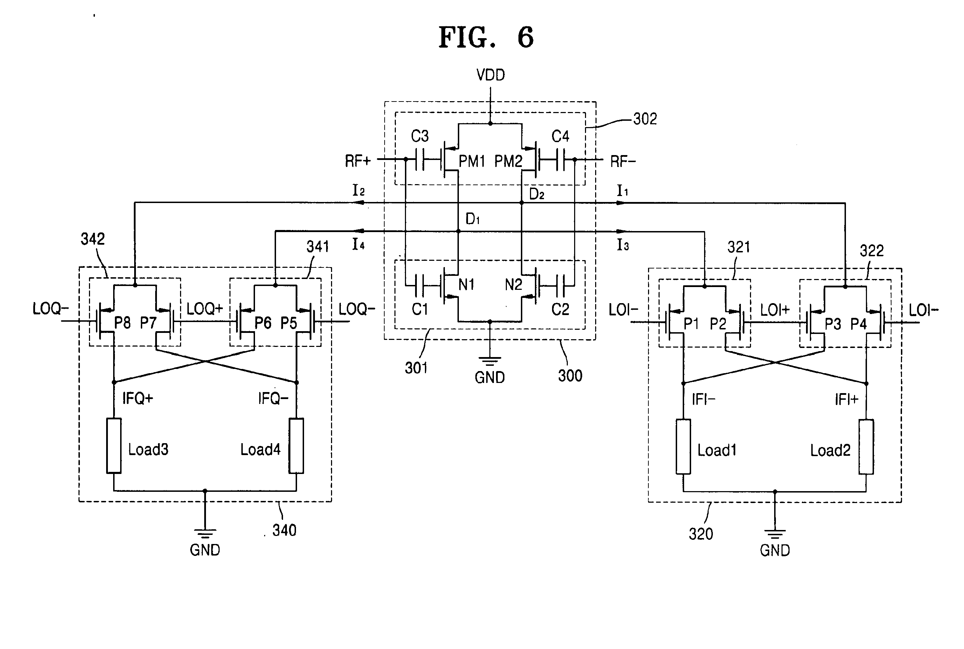

FIG. 6 is a circuit diagram of an I/Q quadrature demodulator according to another exemplary embodiment of the present invention. Referring to FIG. 6, the I/Q quadrature demodulator comprises an input terminal 300, an I mixer 320, and a Q mixer 340.

The I/Q quadrature demodulator has the same constitution as that of the I/Q quadrature demodulator shown in FIG. 5, except that the input terminal 300 further comprises a pair of PMOS transistors PM1 and PM2. Thus, since the constitution of the input terminal 300 and differences in operation thereof will now be described, the same constitution is not described.

The input terminal 300 includes a first path unit 301 and a second path unit 302.

The first path unit 301 comprises a pair of NMOS transistors N1 and N2 having a differential amplifier structure. The second path unit 302 is connected in parallel to the first path unit 301, and the pair of PMOS transistors PM1 and PM2 of the second path unit 302 have a differential amplifier structure.

A drain terminal of the NMOS transistor N1 is connected to a drain terminal of the PMOS transistor PM1, and a drain terminal of the NMOS transistor N2 is connected to a drain terminal of the PMOS transistor PM2.

Gate terminals of the NMOS transistor N1 and the PMOS transistor PM1 are connected to a differential RF voltage signal RF+, and gate terminals of the NMOS transistor N2 and the PMOS transistor PM2 are connected to a differential RF voltage signal RF-. The gate terminals of the MOS transistors N1, N2, PM1, and PM2 constituting the first and second path units 301 and 302 may be connected to the RF signal through bypass capacitors C1 to C4 for blocking a DC input.

Source terminals of the pair of PMOS transistors PM1 and PM2 constituting the second path unit 302 are connected to a power terminal VDD, and source terminals of the pair of NMOS transistors N1 and N2 constituting the first path unit 301 are grounded. An operation of the input terminal 300 having the constitution aforementioned will now be described.

Differential RF voltage signals RF+ and RF- are input to the gate terminals of the MOS transistors N1, N2, PM1, and PM2 constituting the first and second path units 301 and 302.

According to input differential RF voltage signals RF+ and RF-, current flows through the drain terminals of MOS transistors N1, N2, PM1, and PM2 constituting the first and second path units 301 and 302. That is, the differential RF voltage signals RF+ and RF- are converted into current signals.

Since the MOS transistors N1, N2, PM1, and PM2 have a drain impedance of a high value, current that flows through the drain terminals is branched off and input to the I mixer 320 and the Q mixer 340. The I mixer 320 and the Q mixer 340 convert the frequency of current signals, and output differential IF signals IFI+, IFI-, IFQ+, and IFQ-.

The input terminal 300 increases a total value of transconductance by adding the transconductance gₘₙ of the pair of NMOS transistors N1 and N2 constituting the first path unit 301 to the transconductance gₘₚ of the pair of PMOS transistors PM1 and PM2 constituting the second path unit 302 in the drain terminals of the MOS transistors N1, N2, PM1, and PM2. As a value of drain current that flows due to the differential RF voltage signals RF+ and RF- increases, the size of the currents I_{I}, I₂, I₃, and I₄ that flow through the I mixer 320 and the Q mixer 340 increases, thereby increasing conversion gain, and reducing the NF.

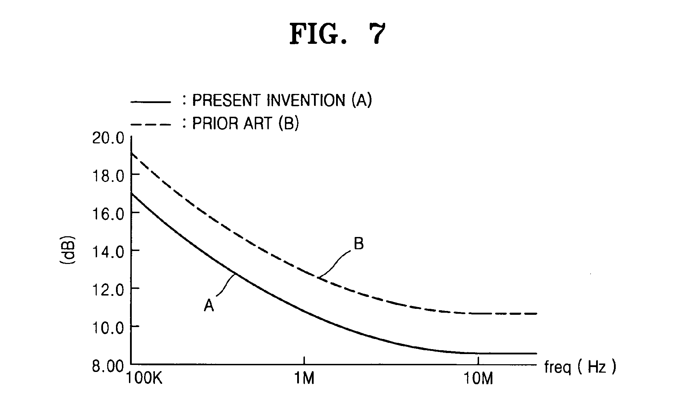

FIG. 7 is a graph illustrating NF curves of the I/Q quadrature demodulator according to an exemplary embodiment of the present invention and a conventional I/Q quadrature demodulator. Referring to FIG. 7, curve A indicates the NF of the I/Q quadrature demodulator according to an exemplary embodiment of the present invention, and curve B indicates the NF of the conventional I/Q quadrature demodulator.

The I/Q quadrature demodulator according to an exemplary embodiment of the present invention has an NF which is 2 dB lower than the conventional I/Q quadrature demodulator. The conventional I/Q quadrature demodulator has a signal having a frequency component corresponding to two times the frequency of the local oscillation signal in the source terminals of MOS transistors constituting the I mixer and the Q mixer. Since the signal having the frequency component is output as it is, it imposes a large burden on a load terminal. However, the I/Q quadrature demodulator according to an exemplary embodiment of the present invention has a signal having a frequency component corresponding to four times the frequency of the local oscillation signal, thereby reducing the burden on the load terminal.

Since in the I/Q quadrature demodulator according to an exemplary embodiment of the present invention, the I mixer 320 and the Q mixer 340 share a single input terminal, it prevents performance deterioration caused by a mismatch between a plurality of input terminals, which occurs in the conventional I/Q quadrature demodulator comprising the plurality of input terminals.

According to the I/Q quadrature demodulator according to an exemplary embodiment of the present invention, the I mixer 320 and the Q mixer 340 share a single input terminal, thereby reducing power consumption.

The I/Q quadrature demodulator according to an embodiment of the present invention increases conversion gain, and reduces NF.

The I/Q quadrature demodulator according to an exemplary embodiment of the present invention reduces errors of the I signal and the Q signal whose frequencies are converted, and improves receive performance.

While the present invention has been particularly shown and described with reference to exemplary embodiments thereof, it will be understood by those of ordinary skill in the art that various changes in form and details may be made therein without departing from the spirit and scope of the present invention as defined by the following claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An I/Q quadrature demodulator that converts a high-frequency signal into an I/Q signal and outputs the I/Q signal, the I/Q quadrature demodulator comprising:
an input terminal (100, 200, 300) which outputs first and second current signals in response to a radio frequency (RF) signal;
an I mixer (120, 220, 320) which converts a frequency of a first current signal output from the input terminal, and outputs a differential in-phase intermediate frequency (IF) signal; and
a Q mixer (140, 240, 340) which converts a frequency of a current signal output from the input terminal, and outputs a differential quadrature-phase IF signal.

2. The I/Q quadrature demodulator of claim 1, wherein the RF signal comprises an RF voltage signal RF+ and an RF voltage signal RF-, and the input terminal (140) comprises:
a first NMOS transistor (N1) including a gate terminal which receives the RF voltage signal RF+, and a drain terminal (D1) which is connected to a power terminal (VDD); and
a second NMOS (N2) transistor including a gate terminal which receives the RF voltage signal RF-, and a drain terminal (D2) which is connected to the power terminal (VDD).

3. The I/Q quadrature demodulator of claim 1, wherein the input terminal comprises:
a first path unit (301) comprising a pair of NMOS transistors (N1, N2) that output current in response to a voltage of the RF signal; and
a second path unit (302) connected to the first path unit in parallel, and comprising a pair of PMOS transistors (PM1, PM2) that output current in response to the voltage of the RF signal.

4. An I/Q quadrature demodulator according to any preceding claim, in which the I mixer converts a frequency of the first current signal and the Q mixer converts the second current signal.

5. An I/Q quadrature demodulator according to claim 1, in which the I mixer receives a differential in-phase oscillation signal.

6. The I/Q quadrature demodulator of claim 5, wherein the RF signal comprises an RF voltage signal RF+ and an RF voltage signal RF-, and the input terminal (100, 200, 300) comprises:
a first NMOS transistor (N1) including a gate terminal which receives the RF voltage signal RF+, a drain terminal which is connected to a power terminal, and a source terminal which is grounded; and
a second NMOS transistor (N2) including a gate terminal which receives the RF voltage signal RF-, a drain terminal which is connected to the power terminal, and a source terminal which is grounded

7. The I/Q quadrature demodulator of claim 6, further comprising first and second current sources (I1, I2) which are connected between drain terminals of the first and second NMOS transistors (N1, N2) and a power terminal, the first and second current sources biasing the first and second NMOS transistors.

8. The I/Q quadrature demodulator of any preceding claim, wherein the I mixer (120, 220, 320) comprises:
first and second PMOS transistors (P1, P2) including source terminals which are connected to each other and to a drain terminal of a first transistor of the input terminal, and gate terminals which receive differential in-phase oscillation signals; and
third and fourth PMOS transistors (P3, P4) which include source terminals which are connected to each other and to a drain terminal of a second transistor of the input terminal, and gate terminals which receive the differential in-phase oscillation signals,
wherein the first and third PMOS transistors further include drain terminals which are connected to each other, and the second and fourth PMOS transistors further include drain terminals which are connected to each other.

9. The I/Q quadrature demodulator of claim 8, wherein the Q mixer (140, 240, 340) comprises:
fifth and sixth PMOS transistors (P5, P6) including source terminals which are connected to each other and to the drain terminal of the first transistor of the input terminal, and gate terminals which receive the differential quadrature-phase oscillation signals; and
seventh and eighth PMOS transistors (P7, P8) which include source terminals connected to each other and to the drain terminal of the second transistor of the input terminal, and gate terminals which receive the differential quadrature-phase oscillation signals,
wherein the fifth and the seventh PMOS transistors further include drain terminals which are connected to each other, and the sixth and the eighth PMOS transistors further include drain terminals which are connected to each other.

10. An I/Q quadrature demodulator that converts a high-frequency signal into an I/Q signal and outputs the I/Q signal, the I/Q quadrature demodulator comprising:
a first path unit (301) comprising a first and second NMOS transistors (N1, N2) that output current in response to a radio frequency (RF) signal; and
a second path unit (302) which is connected to the first path unit in parallel, and comprises first and second PMOS transistors (P1, P2) that output current in response to the RF signal;
an I mixer (120, 320) which is connected to drain terminals of the first and second NMOS and PMOS transistors, converts a frequency of the RF signal based on differential in-phase oscillation signals, and outputs an I signal; and
a Q mixer (140, 340) which is connected to the drain terminals of the first and second NMOS and PMOS transistors, converts a frequency of the input RF signal based on differential quadrature-phase oscillation signals, and outputs a Q signal,
wherein the drain terminals of the first NMOS transistor and the first PMOS transistor are connected to each other, and the drain terminals of the second NMOS transistor and the second PMOS transistor are connected to each other.

11. The I/Q quadrature demodulator of claim 10, wherein the I mixer (120, 320) comprises:
third and fourth PMOS transistors (P3, P4) including source terminals which are connected to each other and to the drain terminals of the first NMOS transistor (N1) and the first PMOS transistor (P1), and gate terminals which receives the differential in-phase oscillation signals; and
fifth and sixth PMOS transistors (P5, P6) including source terminals which are connected to each other and to the drain terminals of the second NMOS and PMOS transistors (N2, P2), and gate terminals which receive the differential in-phase oscillation signals,
wherein the third and the fifth PMOS transistors further include drain terminals which are connected to each other, and the fourth and the sixth PMOS transistors further include drain terminals which are connected to each other.

12. The I/Q quadrature demodulator of claim 11, wherein the Q mixer (140, 340) comprises:
seventh and eighth PMOS transistors (P7, P8) including source terminals which are connected to each other and to the drain terminals of the first NMOS transistor (N1) and the first PMOS transistor (P1), and gate terminals which receive the differential quadrature-phase oscillation signals; and
ninth and tenth PMOS transistors including source terminals which are connected to each other and to the drain terminals of the second NMOS transistor (N2) and the second PMOS transistor (P2), and gate terminals which receive the differential quadrature-phase oscillation signals,
wherein the seventh and ninth PMOS transistors further include drain terminals which are connected to each other, and the eighth and tenth PMOS transistors further include drain terminals which are connected to each other.

13. The I/Q quadrature demodulator of claim 10, wherein gate terminals of the first and second PMOS and NMOS transistors (P1, N1) constituting the first and second path units (301, 302) are connected to the RF signal through bypass capacitors that block a DC input.
